# FASCICULE DE BREVET EUROPEEN

(11) **EP 3 379 539 B1**
(45) Date de publication et mention de la délivrance du brevet: **09.08.2023**
(21) Numéro de dépôt: 18162347.1
(22) Date de dépôt: 16.03.2018
(51) Int. Cl.: G11C 13/00, G11C 7/00, G11C 13/04

(54) **PROCEDE DE FORMAGE D'UNE CELLULE MEMOIRE NON VOLATILE, CELLULE MEMOIRE NON VOLATILE FORMEE SUIVANT CE PROCEDE ET DISPOSITIF MICROELECTRONIQUE COMPORTANT DES TELLES CELLULES MEMOIRE**
FORMVERFAHREN EINER NICHTFLÜCHTIGEN SPEICHERZELLE, NACH DIESEM VERFAHREN GEFORMTE SPEICHERZELLE UND MIKROELEKTRONISCHE VORRICHTUNG, DIE SOLCHE SPEICHERZELLEN UMFASST
METHOD FOR FORMING A NON-VOLATILE MEMORY CELL, NON-VOLATILE MEMORY CELL FORMED BY THIS METHOD AND MICROELECTRONIC DEVICE COMPRISING SUCH MEMORY CELLS

(30) Priorité: 23.03.2017 FR 1752398
(43) Date de publication de la demande: 26.09.2018
(73) Titulaire: Commissariat à l'Energie Atomique et aux Energies Alternatives, 75015 Paris (FR); Université d'Aix-Marseille, 13007 Marseille 7 (FR); Centre National de la Recherche Scientifique - CNRS, 75794 Paris Cedex 16 (FR)
(72) Inventeur: KRAKOVINSKY, Alexis, 13120 GARDANNE (FR); BOCQUET, Marc, 13013 MARSEILLE (FR); COIGNUS, Jean, 38000 GRENOBLE (FR); DELLA MARCA, Vincenzo, 13730 ST VICTORET (FR); PORTAL, Jean-Michel, 13119 SAINT-SAVOURNIN (FR); WACQUEZ, Romain, ALBANY, NY 12203 (US)
(74) Mandataire: Cabinet Camus Lebkiri

(56) Documents cités:
- WO-A1-2010/087836
- CN-A- 102 129 886
- JP-A- 2007 134 512
- US-A1- 2013 044 534
- US-A1- 2013 322 152
- HUET K ET AL: "Laser Thermal Annealing: A low thermal budget solution for advanced structures and new materials", 2014 INTERNATIONAL WORKSHOP ON JUNCTION TECHNOLOGY (IWJT), IEEE, 18 mai 2014 (2014-05-18), pages 1-6, XP032611263, DOI: 10.1109/IWJT.2014.6842020
- VIANELLO E ET AL: "Resistive Memories for Ultra-Low-Power embedded computing design", 2014 IEEE INTERNATIONAL ELECTRON DEVICES MEETING, IEEE, 15 décembre 2014 (2014-12-15), XP032738121, DOI: 10.1109/IEDM.2014.7046995
- KRAKOVINSKY A ET AL: "Impact of a laser pulse on HfO2-based RRAM cells reliability and integrity", 2014 INTERNATIONAL CONFERENCE ON MICROELECTRONIC TEST STRUCTURES (ICMTS), IEEE, 28 mars 2016 (2016-03-28), pages 152-156, XP032903357, ISSN: 1071-9032, DOI: 10.1109/ICMTS.2016.7476196 ISBN: 978-1-4799-2193-5 [extrait le 2016-05-20]

## Description

### DOMAINE TECHNIQUE

La présente invention concerne un procédé de formage d'une cellule mémoire non volatile. L'invention concerne également une cellule mémoire non volatile formée suivant ce procédé et un dispositif microélectronique comportant de telles cellules mémoire. L'invention trouve des applications dans le domaine des mémoires réinscriptibles non volatiles et, plus spécifiquement, celui des mémoires résistives de type OxRRAM (« Oxyde-based Résistive RAM»).

### ETAT DE LA TECHNIQUE

Dans le domaine des mémoires réinscriptibles non volatiles, différents types de mémoires sont utilisés en fonction des applications et des performances visées. Les mémoires les plus couramment utilisées, en particulier dans les appareils photos numériques, les téléphones cellulaires, les ordinateurs portables, le clés USB, et autres dispositifs portables, sont des mémoires appelées « mémoires Flash ». Les mémoires flash offrent, notamment, une forte densité d'intégration, une grande résistance aux chocs et une bonne durabilité.

La plupart des mémoires Flash non-volatiles du commerce utilisent le stockage de charges comme principe de codage de l'information. En pratique, une couche de piégeage de charge (généralement du polysilicium, ou un diélectrique comme le SiN) est encapsulée entre deux diélectriques dans l'empilement de grille d'un transistor MOS. La présence ou l'absence de charge dans ce medium modifie la conduction du transistor MOS et permet de coder l'état de la mémoire.

Toutefois, l'évolution de la microélectronique nécessite une miniaturisation toujours plus poussée des composants et, en particulier, des mémoires réinscriptibles non volatiles. Or, la miniaturisation de la technologie Flash est limitée, notamment par le fait que l'épaisseur de la couche de piégeage de charge ne peut être réduite en dessous d'une valeur minimale (de l'ordre de 6nm) sous peine de diminuer le temps de rétention de l'information.

Récemment, un nouveau type de mémoires, appelées mémoires résistives, ont fait leur apparition pour remplacer les mémoires Flash. Ces mémoires résistives ne reposent pas sur le piégeage de charge des grilles de transistors, mais sur un changement d'état d'un bloc résistif. Les mémoires résistives, notamment les mémoires résistives à base d'oxyde OxRRAM, sont basées sur un changement de l'état de résistance (forte ou faible résistance) d'un matériau actif intégré entre deux électrodes métalliques. Ce nouveau type de mémoire permet, non seulement une forte densité d'intégration, mais également une vitesse de fonctionnement élevée, une grande endurance et une bonne compatibilité avec les procédés de fabrication utilisés actuellement dans l'industrie microélectronique, en particulier avec les procédés de fin de ligne de la technologie CMOS.

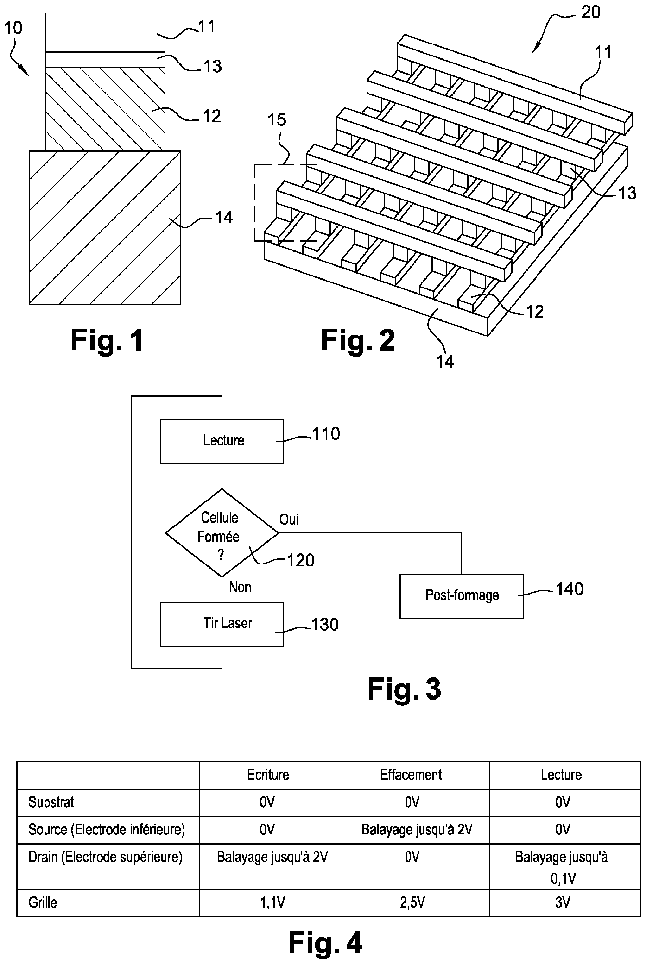

Une mémoire résistive comprend généralement une pluralité de cellules mémoire, appelées également points mémoire. Chaque cellule mémoire comporte un bloc résistif tel qu'un memristor formé d'une première et d'une seconde électrodes, généralement en métal, et d'une couche en matériau actif, par exemple un oxyde de métal, disposé entre les deux électrodes. Un exemple d'une cellule mémoire résistive de type OxRRAM est représenté sur la figure 1. Cette mémoire résistive 10 comporte une première électrode 11, une seconde électrode 12 et une couche en matériau actif 13 agencée entre les première et seconde électrodes. La seconde électrode 12 de la mémoire résistive 1 est ménagée au contact d'un substrat connecteur 14 assurant un contact électrique entre un dispositif de sélection (non représenté sur la figure 1) et la cellule mémoire. Le dispositif de sélection, par exemple un transistor, permet de contrôler la tension ou le courant appliqué aux électrodes 11 et 12 du memristor.

La couche de matériau actif 13, généralement un matériau initialement isolant, est apte à commuter, de manière réversible, entre deux états de résistance qui correspondent aux valeurs logiques « 0 » et « 1 » utilisées pour coder un bit d'information. Ainsi, une cellule mémoire résistive peut basculer d'un état conducteur faiblement résistif LRS ( « Low Resistance State » en termes anglo-saxons) à un état conducteur hautement résistif HRS ( « High Resistance State » en termes anglo-saxons) par l'application d'une première tension VRESET entre la première 11 et la seconde 12 électrodes, et rebasculer de l'état conducteur hautement résistif HRS à l'état conducteur faiblement résistif LRS par l'application d'une deuxième tension VSET entre les première et seconde électrodes. En particulier, une information est écrite dans la cellule mémoire en basculant la couche en matériau actif de l'état fortement résistif HRS, appelé également état « OFF », à l'état faiblement résistif LRS, ou état « ON ». À l'inverse, une information peut être effacée de la cellule mémoire en basculant la couche en matériau actif de l'état LRS vers l'état HRS. L'opération d'écriture dans le cellule mémoire est appelée « SET » ; l'opération d'effacement de ladite cellule mémoire est appelée « RESET ».

Le changement de résistance du matériau actif est gouverné par la formation et la rupture d'un filament conducteur de section nanométrique entre les deux électrodes 11-12. En l'état actuel des connaissances, ce filament semble être dû à des phénomènes différents, dépendant du type de matériau utilisé pour la couche de matériau actif. En particulier, dans une mémoire résistive de type OxRRAM dans laquelle la couche de matériau actif est à base d'oxyde, le changement d'état résistif semble s'expliquer par la formation d'un filament de lacunes d'oxygène au sein de ladite couche de matériau actif.

Dans un état initial, c'est-à-dire après fabrication mais avant formage de la cellule mémoire, la couche de matériau actif 13 est isolante. La couche de matériau isolant est rendue active par le procédé de formage (appelé « forming » en termes anglo-saxons) réalisé avant utilisation de la cellule mémoire. Ce procédé de formage consiste, généralement, à réaliser un claquage partiellement réversible du matériau isolant afin de générer, pour la première fois, un état conducteur faiblement résistif LRS dans ladite couche de matériau 13. Le claquage permet d'initier la création du filament conducteur dans la couche de matériau 13. Après claquage, le matériau initialement isolant devient actif et la résistance dudit matériau peut être modulée pour passer d'un état LRS à un état HRS, et inversement.

Généralement, l'opération de claquage du matériau isolant comporte l'application d'un premier stress électrique sur la cellule mémoire vierge. Ce stress électrique doit être réalisé à une tension de valeur bien supérieure à la tension nominale de fonctionnement de ladite cellule mémoire, par exemple une tension de l'ordre de 2,5V pour une tension nominale de l'ordre de 1,5V.

Or, l'utilisation de tels niveaux de potentiels peut être néfaste pour les composants avoisinants la couche de matériau actif 13 et, par exemple, détériorer le dispositif de sélection conçu pour fonctionner à des potentiels inférieurs. L'utilisation de tels niveaux de potentiels nécessite donc un design spécifique - relativement coûteux - permettant de protéger le dispositif de sélection et les éventuels autres composants avoisinants, ce design spécifique étant d'autant plus coûteux qu'il est prévu pour n'être utilisé qu'une seule fois durant la vie de la mémoire résistive (pour l'opération de formage).

Pour répondre à ce problème de tension de formage trop élevée, il a été proposé d'utiliser des cellules mémoires dont la couche de matériau actif est de faible épaisseur (typiquement inférieure à 3nm). Une telle proposition est décrite, notamment, dans le document de B. Traore et al, intitulé « On the forming-free operation of HfOx based RRAM devices: Experiments and ab initio calculations", Solid-State Device Research Conférence (ESSDERC), 2013 Proceedings of the European, Bucharest, 2013, pp. 170-173. Cependant, si cette faible épaisseur de la couche de matériau actif permet de réaliser un claquage à un niveau de potentiel sensiblement similaire aux potentiels utilisés pour l'opération d'écriture, la structure obtenue est beaucoup moins stable que celle d'une cellule mémoire ayant une couche de matériau isolant épaisse. En effet, du fait de la faible épaisseur de la couche de matériau actif, les niveaux de résistance de l'état fortement résistif (HRS) et de l'état faiblement résistif (LRS) sont variables et donc instables. De telles cellules mémoire ne sont donc pas viables durablement. Le document US 2013/322152 A1 décrit des procédés de formage pour des cellules mémoire.

Des techniques, basées sur l'exposition des cellules mémoire à des moyens extérieurs comme la température ou les rayonnements UV, ont été étudiées pour améliorer la stabilité des états faiblement et/ou hautement résistifs de la couche de matériau actif. Le document de A. Krakovinsky et al., intitulé « Impact of a Laser Pulse On HfO2-based RRAM Cells Reliability and Integrity », ICMTS 2016, propose, par exemple, de réaliser une opération d'écriture d'une cellule mémoire résistive au moyen d'un laser. Toutefois, ces techniques cherchent à améliorer la stabilité des états résistifs de la couche de matériau actif d'une cellule mémoire formée. Ces techniques ne permettent pas le formage de cellules mémoire résistives.

### RESUME DE L'INVENTION

Pour répondre au problème évoqué ci-dessus des tensions de formage trop élevées pour être supportées par les dispositifs de sélection, le demandeur propose un procédé de formage d'une cellule mémoire résistive dans lequel l'opération de claquage est réalisée par au moins un tir laser.

Selon un premier aspect, l'invention concerne un procédé de formage d'une cellule mémoire non volatile destiné à faire commuter ladite cellule mémoire d'un état non-formé à un état formé, ladite cellule mémoire comprenant un empilement ordonné d'une électrode inférieure, d'une couche de matériau isolant et d'une électrode supérieure. Ce procédé se caractérise par le fait qu'il comporte une opération de claquage dans laquelle au moins un tir laser est émis vers la couche de matériau isolant pour rendre ladite couche de matériau isolant active en la faisant passer d'un état fortement résistant (état HRS) à un état faiblement résistant (état LRS), la cellule mémoire étant formée lorsque la couche de matériau isolant est active, plusieurs tirs laser étant en mesure d'être émis successivement vers la couche de matériau isolant (13) avec, chacun, une puissance surfacique de tir supérieure à la puissance surfacique de tir du tir laser précédent, un premier tir laser étant appliqué avec une puissance surfacique prédéterminée de base, les tirs laser suivants étant appliqués avec une puissance surfacique augmentée pas à pas jusqu'à ce qu'un des tirs laser produise le claquage de la couche de matériau isolant.

Une telle opération de claquage de la couche de matériau isolant par tir laser présente l'avantage de pouvoir être mise en oeuvre sur des cellules mémoire hors alimentation électrique. Cette opération de claquage permet donc d'éviter l'utilisation de niveaux de potentiels élevés et les conséquences néfastes qu'ils peuvent entrainer. Elle permet ainsi de former la cellule mémoire sans nécessiter aucun design spécifique, ce qui permet un formage moins coûteux que le formage par application d'un stress électrique.

Dans la description qui suit, les expressions « couche de matériau isolant », « couche de matériau actif » et « matériau actif » décrivent la même couche de matériau comprise entre l'électrode inférieure et l'électrode supérieure, étant entendu que cette couche de matériau est fortement résistive (et donc sensiblement isolante) à l'état initial et à l'état HRS et faiblement résistive (et donc électriquement conductrice) à l'état LRS. L'homme du métier comprendra que cette couche de matériau est considérée comme active car, après claquage, elle est apte à passer, de façon réversible, d'un état fortement résistif à un état faiblement résistif en fonction de la tension appliquée aux bornes des électrodes inférieure et supérieure.

De façon avantageuse, le procédé de formage comporte les étapes suivantes :
a) lecture de la cellule mémoire,
b) détection de l'état formé ou non-formé de ladite cellule mémoire,
c) lorsque la cellule mémoire est dans un état non-formé, mise en oeuvre de tirs laser,
d) lorsque la cellule mémoire est dans un état formé, réalisation d'un cycle de post-formage pour mettre ladite cellule en état de fonctionnement.

Cette variante du procédé de formage permet non seulement de faire passer la cellule mémoire d'un état non-formé à un état formé, mais également de mettre la cellule mémoire formée dans un état de fonctionnement.

Selon certains modes de réalisation, les étapes a) - c) sont répétées tant que la cellule mémoire est dans un état non-formé, la puissance surfacique du tir laser étant augmentée à chaque répétition de l'étape c).

Le fait d'augmenter peu à peu la puissance surfacique du tir laser permet un claquage optimal des cellules mémoire dans lequel chaque cellule mémoire est formée avec le niveau de puissance surfacique qui lui est nécessaire.

Selon certains modes de réalisation, le cycle de post-formage de l'étape d) comporte plusieurs cycles, successifs et réversibles, de commutation entre l'état HRS et l'état LRS.

Selon certains modes de réalisation, l'opération de claquage est réalisée avec un laser d'une puissance surfacique comprise entre 0.06 et 0.12 W/µm².

Selon certains modes de réalisation, l'opération de claquage est réalisée avec un faisceau laser d'un diamètre supérieur à trois fois la largeur et/ou la longueur de la cellule mémoire. Un tel diamètre permet d'assurer le claquage de la surface entière de la couche de matériau isolant.

Selon certains modes de réalisation, l'opération de claquage est réalisée avec un laser dont les impulsions ont une durée inférieure ou égale à 1 µs.

Selon certains modes de réalisation, l'opération de claquage est réalisée avec un faisceau laser émis dans une longueur d'onde de l'infrarouge ou de l'ultraviolet.

Selon un second aspect, l'invention concerne une cellule mémoire non volatile comprenant un empilement ordonné d'une électrode inférieure, d'une couche de matériau isolant et d'une électrode supérieure. Cette cellule mémoire se caractérise par le fait que la couche de matériau isolant est rendue active par un procédé de formage tel que défini ci-dessus de sorte que ladite couche de matériau isolant soit apte, après formage, à commuter de manière réversible entre un état fortement résistant (état HRS) et un état faiblement résistant (état LRS).

Une telle cellule mémoire présente ainsi des caractéristiques intrinsèques similaires à celles d'une cellule mémoire formée par un procédé de formage par application d'un stress électrique.

Selon certains modes de réalisation, l'électrode supérieure est en Titane (Ti), l'électrode inférieure est en Nitrure de Titane (TiN) et la couche de matériau isolant est en Oxyde d'Hafnium (HfO₂).

Selon certains modes de réalisation, la cellule mémoire comporte un dispositif de sélection, connecté à l'empilement de l'électrode inférieure, de la couche de matériau isolant et de l'électrode supérieure, pour contrôler le courant circulant dans ledit empilement.

Selon un troisième aspect, l'invention concerne un dispositif microélectronique comportant une pluralité de cellules mémoire telles que définies précédemment, agencées les unes à côté des autres.

Selon certains modes de réalisation, les cellules mémoire du dispositif microélectronique sont agencées dans une architecture de type croisé.

### BREVE DESCRIPTION DES FIGURES

D'autres avantages et caractéristiques de l'invention apparaîtront à la lecture de la description, illustrée par les figures dans lesquelles :
- La figure 1, déjà décrite, représente schématiquement un exemple de cellule mémoire résistive de type OxRRAM ;
- La figure 2 représente schématiquement un exemple d'un dispositif microélectronique comportant plusieurs cellules mémoire résistives selon l'invention ;
- La figure 3 représente schématiquement le diagramme fonctionnel du procédé de formage d'une cellule mémoire résistive selon la présente invention ;
- La figure 4 représente, sous la forme d'un tableau, des exemples des valeurs de tension à appliquer à une cellule mémoire en phases d'écriture et d'effacement de ladite cellule ;
- Les figures 5A et 5B représentent des exemples de valeurs de résistances, respectivement à l'état HRS et à l'état LRS, obtenues par une cellule mémoire formée par le procédé de formage selon l'invention.

### DESCRIPTION DETAILLEE D'AU MOINS UN MODE DE REALISATION

Un exemple d'un procédé de formage d'une cellule mémoire résistive mis en oeuvre par émission d'au moins un tir laser est décrit en détail ci-après, en référence aux dessins annexés. Cet exemple illustre les caractéristiques et avantages de l'invention. Il est toutefois rappelé que l'invention ne se limite pas à cet exemple.

Sur les figures, les éléments identiques sont repérés par des références identiques. Pour des questions de lisibilité des figures, les échelles de taille entre éléments représentés ne sont pas respectées.

Un dispositif microélectronique selon l'invention, appelé également mémoire résistive, est représenté sur la figure 2. Ce dispositif microélectronique 20 comporte une pluralité de cellules mémoire résistives 10, appelées aussi indifféremment cellules mémoire non-volatiles ou simplement cellules mémoire. Cette pluralité de cellules mémoire 10 - du type de la cellule mémoire représentée sur la figure 1 - sont agencées les unes à côté des autres, sur un ou plusieurs étages. Dans l'exemple de la figure 2, les cellules mémoire 10 sont agencées selon une architecture croisée (ou « Cross-bar » selon l'expression anglo-saxonne), dans laquelle plusieurs électrodes supérieures 11 sont agencées parallèlement les unes aux autres dans un premier plan et plusieurs électrodes inférieures 12 sont agencées parallèlement les unes aux autres et perpendiculairement aux électrodes supérieures 11, dans un second plan parallèle au premier plan. Une couche de matériau actif 13 est ménagée à chaque intersection entre une électrode inférieure et une électrode supérieure. Chaque empilement constitué d'une portion d'électrode inférieure 12, d'une portion d'électrode supérieure 11 et d'une couche de matériau actif 13 forme un memristor 15. Chaque memristor 15 est associé avec un dispositif de sélection, non représenté sur la figure 2, de sorte à former une cellule mémoire telle que celle représentée sur la figure 1.

Les électrodes inférieure 12 et supérieure 11 sont des électrodes métalliques, par exemple en Titane (Ti) pour l'électrode supérieure 11 et en Nitrure de Titane (TiN) pour l'électrode inférieure 12. Les électrodes supérieure 11 et inférieure 12 peuvent bien entendu être réalisées dans d'autres matériaux utilisés habituellement dans les cellules RRAM (Résistive Random-Access Memory, en termes anglo-saxons) comme le Tantale (Ta) ou le Nitrure de Tantale (TaN).

La couche de matériau actif 13 est une couche d'un matériau originellement isolant tel que l'Oxyde de Hafnium (HfO₂). Cette couche peut avoir une épaisseur, par exemple, de 10 nm. Ce matériau actif, isolant à l'origine, est capable de devenir conducteur après une opération de claquage qui sera décrite ultérieurement. Ainsi, sous l'effet d'une tension appliquée sur les électrodes supérieure et inférieure, la couche de matériau actif 13 devient hautement résistive ou faiblement résistive, selon le niveau de tension appliqué.

Dans un exemple particulier d'application, le dispositif microélectronique 20 comporte une pluralité de cellules mémoire résistives 10 agencées selon une architecture croisée. Dans l'exemple de la figure 2, chaque cellule mémoire du dispositif microélectronique est de dimensions 3µm par 3µm et comporte une couche active 13 en Oxyde de Hafnium de 10nm. Chaque cellule mémoire 10 du dispositif microélectronique comporte également un dispositif de sélection connecté au memristor 15 pour contrôler le niveau de courant appliqué audit memristor. Dans certains modes de réalisation, le dispositif de sélection est un transistor de type N6MOS à prise substrat P+, comportant une largeur de grille de 0,35µm et une largeur de zone active de 100 µm. La largeur de grille est un paramètre important dans le choix du transistor de sélection car c'est cette grille qui détermine le courant maximum - appelé courant de compilance - autorisé dans la cellule mémoire. En effet, un courant suffisamment élevé, par exemple un courant maximum de 3mA, doit pouvoir traverser la grille du transistor pour permettre une commutation réversible de la cellule mémoire entre l'état LRS et l'état HRS ; ce courant doit toutefois être limité afin d'empêcher la création d'un filament conducteur permanent dans la couche de matériau actif.

Pour écrire, effacer et/ou réécrire dans une cellule mémoire résistive 10, ladite cellule mémoire doit être formée, c'est-à-dire que la couche de matériau actif 13 doit avoir été « claquée » lors d'une opération de claquage afin que ladite couche de matériau actif puisse être au moins partiellement conductrice. Cette opération de claquage consiste à initier la création du filament conducteur dans la couche de matériau actif 13 de sorte que ledit matériau actif soit apte à commuter d'un état faiblement résistif (état LRS) à un état hautement résistif (état HRS), ou inversement.

Cette opération de claquage est réalisée au cours du procédé de formage selon l'invention, représenté schématiquement sur la figure 3. Ce procédé de formage, référencé 100, comporte une étape 110 de lecture d'une cellule mémoire. En effet, lors de la phase de production d'un dispositif microélectronique tel que celui de la figure 2, chaque cellule mémoire du dispositif microélectronique est lue pour vérifier qu'elle est non-formée ou, au contraire, formée. Ainsi, chaque cellule mémoire est lue à l'étape 110 et un test de vérification de l'état formé ou non formé de ladite cellule mémoire est exécuté à l'étape 120. Si la cellule mémoire est déterminée comme non-formée, alors le procédé se poursuit par une étape 130 de tir laser. Un premier tir laser est effectué avec une puissance surfacique prédéterminée, par exemple de 0,03 W/µm². Après ce premier tir laser, la cellule mémoire est à nouveau lue à l'étape 110 pour vérifier si ce tir laser a permis de claquer la couche de matériau actif 13 de sorte à former la cellule mémoire. Si au test 120, la cellule mémoire est détectée comme toujours non formée, alors un deuxième tir laser (étape 130) est effectué sur la couche de matériau actif 13, avec une puissance surfacique supérieure à la puissance surfacique du premier tir laser. Les étapes 110 - 130 sont ainsi réitérées, avec une puissance surfacique de tir augmentée à chaque itération, jusqu'au claquage de la couche de matériau actif 13. L'augmentation de la puissance surfacique entre chaque tir peut être réalisée avec un pas, par exemple de 0,01 W/µm² jusqu'à une valeur, par exemple, de 0,12 W/µm². Autrement dit, les étapes 110-130 sont répétées jusqu'à ce que la cellule mémoire soit détectée comme formée à l'étape 120.

Chaque tir laser produit, sur la cellule mémoire, une montée en température qui est à l'origine du claquage de la couche de matériau actif. En effet, l'impact d'un faisceau laser sur une couche de matériau actif à base d'oxyde génère un effet thermique (ou montée en température) apte à créer le filament conducteur dans la couche de matériau actif. Plus la puissance surfacique du faisceau laser est élevée, plus la chaleur dégagée par le tir laser est élevée. Le procédé de l'invention propose d'appliquer une puissance surfacique prédéterminée de base, par exemple de 0,03 W/µm2, et d'augmenter cette puissance surfacique pas à pas jusqu'à ce que la chaleur dégagée par le tir laser produise le claquage.

Dans le procédé de la figure 3, lorsque la cellule mémoire est détectée, à l'étape 120, comme étant formée, alors un cycle de post-formage est effectué sur la cellule mémoire à l'étape 140. Ce cycle de post-formage 140 consiste à faire commuter plusieurs fois de suite (par exemple une dizaine de fois) la cellule mémoire d'un état HRS à un état LRS, et inversement, de sorte à mettre la cellule mémoire en état de fonctionnement. Des exemples des tensions appliquées pendant ce cycle de post-formage sont représentés sur la figure 4. En effet, en fonction de la tension appliquée à la cellule mémoire, la couche de matériau actif 13 passe dans un état HRS ou dans un état LRS. Le tableau de la figure 4 montre des exemples de tensions appliquées à l'électrode inférieure 12, via la source du transistor de sélection, à l'électrode supérieure 11 via le drain du transistor, à la grille du transistor et au substrat 14. Selon cet exemple, lors de la lecture de la cellule mémoire 10, une tension de 0V est appliquée au substrat et à l'électrode inférieure, une tension de 3V est appliquée à la grille et une tension de balayage allant jusqu'à 0,1V est appliquée à l'électrode supérieure. Pendant la phase d'écriture de la cellule mémoire, une tension de 0V est appliquée au substrat et à l'électrode inférieure, une tension de 1,1V est appliquée à la grille et une tension de balayage allant jusqu'à 2V est appliquée à l'électrode supérieure. Pendant la phase d'effacement de la cellule mémoire, une tension de 0V est appliquée au substrat et à l'électrode supérieure, une tension de 2,5V est appliquée à la grille et une tension de balayage allant jusqu'à 2V est appliquée à l'électrode inférieure.

L'opération de claquage de la couche de matériau actif 13 est mise en oeuvre au moyen d'un faisceau laser dont certains paramètres sont prédéfinis en fonction de la cellule mémoire considérée. L'un de ces paramètres est la puissance par unité de surface. Cette puissance par unité de surface, qui détermine l'impact du faisceau laser sur la cellule mémoire, est définie en fonction de plusieurs critères tels que les dimensions de la cellule mémoire et le matériau actif utilisé. Cette puissance par unité de surface peut être, par exemple, une puissance comprise entre 0,06 et 0,12 W/µm². La dimension du spot du faisceau laser, c'est-à-dire la dimension de la tache du faisceau impactant la cellule mémoire, est également un paramètre prédéfini, notamment en fonction de la taille de la cellule mémoire et du type de matériau actif choisi. Le diamètre du spot laser est choisi, par exemple supérieur à trois fois la dimension du memristor, de sorte à concentrer la majeure partie de la puissance du faisceau laser dans la couche de matériau actif abritant le filament conducteur. Par exemple, dans un mode de réalisation où le memristor a une largeur et une longueur de 3 µm chacun, le spot laser pourra être choisi avec un diamètre égal ou supérieur à 9 µm. La durée d'impulsion du faisceau laser est un paramètre supplémentaire, défini en fonction de critères tels que les dimensions de la cellule mémoire et le choix des matériaux. La durée d'impulsion est déterminée de façon à maintenir l'intégrité de la cellule mémoire et ne pas endommager les matériaux situés autour de la couche de matériau actif comme les électrodes et les matériaux de connexion. Cette durée d'impulsion peut être, par exemple, inférieure ou égale à 1 µs.

Le procédé de formage de l'invention peut être mis en oeuvre à plusieurs longueurs d'onde. Par exemple, la source laser peut émettre des faisceaux à une longueur d'onde dans les ultraviolets (longueur d'onde comprise entre environ 100 et 400 nm) ou dans les infrarouges (longueur d'onde comprise entre environ 800 et 1400 nm).

Dans le mode de réalisation où le memristor a une largeur et une longueur de 3 µm chacun, les tirs laser peuvent, par exemple, être réalisés avec un spot laser de 50x50 µm², émis avec une source laser de type Nd -Yag (grenat d'yttrium-aluminium dopé au néodyme) dont l'impulsion, pendant 10 ns, peut atteindre une puissance surfacique de 7,2 W/µm², dans une longueur d'onde de 355nm ou 1064 nm.

Le claquage de la couche de matériau actif 13 peut être obtenu pour une puissance surfacique comprise entre environ 0,022 et 0,09 W/µm². La valeur de la puissance laser nécessaire pour faire claquer la couche de matériau actif, appelée « seuil de claquage », est variable d'une cellule mémoire à une autre. En effet, une cellule mémoire résistive étant un composant analogique, il existe, comme pour tout composant analogique, une certaine variabilité de réaction. Cette variabilité est encore accentuée en fonction des matériaux utilisés pour fabriquer la cellule mémoire. Dans le mode de réalisation du memristor exposé précédemment, le seuil de claquage de certaines cellules mémoire du dispositif microélectronique 20 peut être à 0,025 W/µm² en infrarouge (ou 0,022 W/µm² en ultraviolet), celui d'autres cellules peut être à 0,06 W/µm² en infrarouge (ou 0,047 W/µm² en ultraviolet) ou encore à 0,09 W/µm² en infrarouge (ou 0,072 W/µm² en ultraviolet). Cette variabilité, sensiblement identique en infrarouge et en ultraviolet, est anticipée, dans le procédé de l'invention, par une détermination pas à pas du seuil de claquage, réalisée en augmentant la puissance surfacique du tir laser à chaque itération de l'étape 130 du procédé de la figure 3. La détermination pas à pas du seuil de claquage permet donc de réaliser un claquage optimal de chaque cellule mémoire avec la puissance surfacique la mieux appropriée pour ladite cellule mémoire. La détermination pas à pas du seuil de claquage permet en outre de s'affranchir du contrôle du courant pendant l'opération de claquage. L'opération de claquage par tir laser peut donc être mise en oeuvre pendant que la cellule mémoire est hors tension, c'est-à-dire qu'elle n'est pas alimentée électriquement.

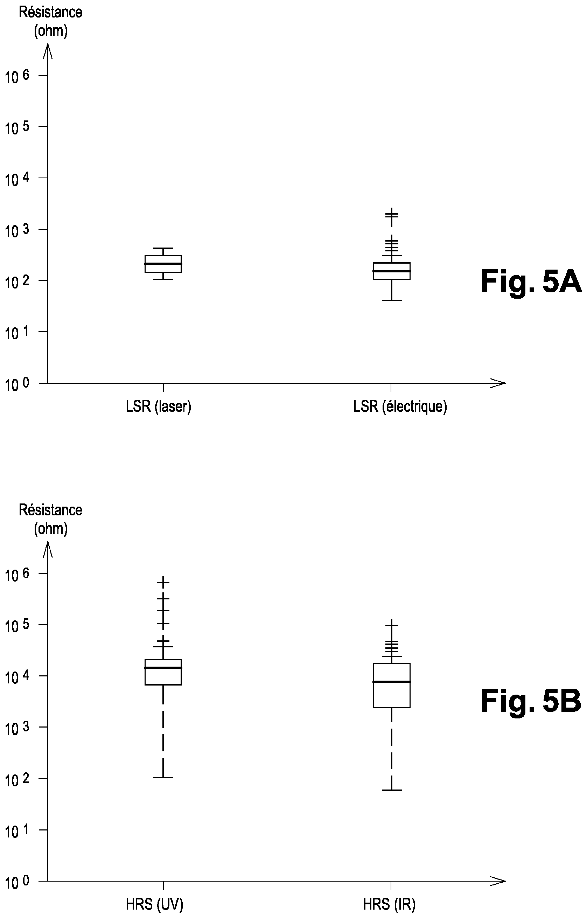

Avec un claquage optimal, les valeurs des résistances des couches de matériau actif obtenues après claquage sont optimales, c'est-à-dire de l'ordre de 200 Ω à l'état LRS et de l'ordre de 10kΩ à l'état HRS, comme représenté sur les figures 5A et 5B. En particulier, la figure 5A montre que la valeur moyenne des résistances obtenues avec le claquage selon le procédé de l'invention, à l'état LRS, est proche de la valeur moyenne des résistances obtenues avec un procédé classique de claquage par application d'une tension de formage. La figure 5A montre donc que le procédé selon l'invention permet d'obtenir un niveau résistif des cellules mémoire similaire à celui obtenu avec un procédé de formage classique, sans toutefois risquer l'endommagement des composants avoisinants. La figure 5A montre également que les valeurs des résistances obtenues avec le claquage selon le procédé de l'invention sont plus concentrées, et donc plus proches les unes des autres, que les valeurs des résistances obtenues avec un procédé de claquage classique.

La figure 5B montre que la valeur moyenne des résistances obtenues avec un claquage réalisé par un laser émettant dans le spectre infrarouge, à l'état HRS, est proche de la valeur moyenne des résistances obtenues avec un claquage réalisé par un laser émettant dans le spectre ultraviolet.

Ainsi, le procédé selon l'invention permet le formage de cellules mémoire hors alimentation électrique et donc sans risque de sur-claquage par application d'une tension trop élevée. Le procédé selon l'invention permet ainsi l'obtention de cellules mémoire résistives optimales sans nécessiter aucun design spécifique, ce qui permet un formage à moindre coût.

Bien que décrit à travers un certain nombre d'exemples, variantes et modes de réalisation, le procédé de formage selon l'invention et la cellule mémoire formée par ce procédé comprend divers variantes, modifications et perfectionnements qui apparaîtront de façon évidente à l'homme du métier, étant entendu que ces variantes, modifications et perfectionnements font partie de la portée de l'invention, telle que définie par les revendications qui suivent.

## Revendications

1. Procédé de formage (100) d'une cellule mémoire non volatile destiné à faire commuter ladite cellule mémoire (10) d'un état non-formé à un état formé, ladite cellule mémoire comprenant un empilement ordonné d'une électrode inférieure (12), d'une couche de matériau isolant (13) et d'une électrode supérieure (11),
**caractérisé en ce qu'**il comporte une opération de claquage (110-130) dans laquelle au moins un tir laser est émis vers la couche de matériau isolant (13) pour rendre ladite couche de matériau isolant active en la faisant passer d'un état fortement résistant (état HRS) à un état faiblement résistant (état LRS), la cellule mémoire étant formée lorsque la couche de matériau isolant est active, plusieurs tirs laser étant en mesure d'être émis successivement vers la couche de matériau isolant (13) avec, chacun, une puissance surfacique de tir supérieure à la puissance surfacique de tir du tir laser précédent, un premier tir laser étant appliqué avec une puissance surfacique prédéterminée de base, les tirs laser suivants étant appliqués avec une puissance surfacique augmentée pas à pas jusqu'à ce qu'un des tirs laser produise le claquage de la couche de matériau isolant (13).

2. Procédé de formage selon la revendication 1, **caractérisé en ce qu'**il comporte les étapes suivantes :
a) lecture (110) de la cellule mémoire,
b) détection (120) de l'état formé ou non-formé de ladite cellule mémoire,
c) lorsque la cellule mémoire est dans un état non-formé, mise en oeuvre de tirs laser (130),
d) lorsque la cellule mémoire est dans un état formé, réalisation d'un cycle de post-formage (140) pour mettre ladite cellule en état de fonctionnement.

3. Procédé de formage selon la revendication 2, **caractérisé en ce que** les étapes a) - c) sont répétées tant que la cellule mémoire (10) est dans un état non-formé, la puissance surfacique du tir laser étant augmentée à chaque répétition de l'étape c).

4. Procédé de formage selon l'une quelconque des revendications 2 à 3, **caractérisé en ce que** le cycle de post-formage (140) de l'étape d) comporte plusieurs cycles, successifs et réversibles, de commutation entre l'état HRS et l'état LRS.

5. Procédé de formage selon l'une quelconque des revendications 1 à 4, **caractérisé en ce que** l'opération de claquage est réalisée avec un laser d'une puissance surfacique comprise entre 0.06 et 0.12 W/µm².

6. Procédé de formage selon l'une quelconque des revendications 1 à 5, **caractérisé en ce que** l'opération de claquage est réalisée avec un faisceau laser d'un diamètre supérieur à trois fois la largeur et/ou la longueur de la cellule mémoire.

7. Procédé de formage selon l'une quelconque des revendications 1 à 6, **caractérisé en ce que** l'opération de claquage est réalisée avec un laser dont les impulsions ont une durée inférieure ou égale à 1µs.

8. Procédé de formage selon l'une quelconque des revendications 1 à 7, **caractérisé en ce que** l'opération de claquage est réalisée avec un faisceau laser émis dans une longueur d'onde de l'infrarouge ou de l'ultraviolet.

9. Cellule mémoire non volatile (10) comprenant un empilement ordonné d'une électrode inférieure (12), d'une couche de matériau isolant (13) et d'une électrode supérieure (11),
**caractérisée en ce que** la couche de matériau isolant (13) est rendue active par un procédé de formage selon l'une quelconque des revendications 2 à 4 de sorte que ladite couche de matériau isolant soit apte, après formage, à commuter de manière réversible entre un état fortement résistant (état HRS) et un état faiblement résistant (état LRS).

10. Cellule mémoire selon la revendication 9, **caractérisée en ce que** l'électrode supérieure est en Titane (Ti), l'électrode inférieure est en Nitrure de Titane (TiN) et la couche de matériau isolant est en Oxyde d'Hafnium (HfO₂).

11. Cellule mémoire selon la revendication 9 ou 10, **caractérisée en ce qu'**elle comporte un dispositif de sélection, connecté à l'empilement de l'électrode inférieure, de la couche de matériau isolant et de l'électrode supérieure, pour contrôler le courant circulant dans ledit empilement.

12. Dispositif microélectronique (20) comportant une pluralité de cellules mémoire (10) selon l'une quelconque des revendications 9 à 11, agencées les unes à côté des autres.

13. Dispositif microélectronique selon la revendication 12, **caractérisé en ce que** les cellules mémoire (10) sont agencée dans une architecture de type croisé.

## Patentansprüche

1. Formgebungsverfahren (100) einer nichtflüchtigen Speicherzelle zum Umschalten der Speicherzelle (10) von einem nicht geformten Zustand in einen geformten Zustand, wobei die Speicherzelle eine geordnete Schichtung aus einer unteren Elektrode (12), einer Schicht aus isolierendem Material (13) und einer oberen Elektrode (11) umfasst,
**dadurch gekennzeichnet, dass** es einen Durchschlagvorgang (110-130) umfasst, bei dem mindestens ein Laserschuss in Richtung der Isoliermaterialschicht (13) abgegeben wird, um die Isoliermaterialschicht zu aktivieren, indem sie von einem hochfesten Zustand (HRS-Zustand) in einen niedrigfesten Zustand (LRS-Zustand) überführt wird, wobei die Speicherzelle gebildet wird, wenn die Isoliermaterialschicht aktiv ist, mehrere Laserschüsse nacheinander auf die Isoliermaterialschicht (13) abgegeben werden können, wobei jeder eine Schussflächenleistung hat, die größer ist als die Schussflächenleistung des vorhergehenden Laserschusses, wobei ein erster Laserschuss mit einer vorbestimmten Grundflächenleistung angewendet wird und die nachfolgenden Laserschüsse mit einer schrittweise erhöhten Flächenleistung angewendet werden, bis einer der Laserschüsse den Durchschlag der Isoliermaterialschicht (13) bewirkt.

2. Formgebungsverfahren nach Anspruch 1, **dadurch gekennzeichnet, dass** es folgende zusätzliche Schritte umfasst:
a) Lesen (110) der Speicherzelle,
b) Erfassen (120) des geformten oder nicht geformten Zustands der Speicherzelle,
c) wenn sich die Speicherzelle in einem nicht-geformten Zustand befindet, Ausführen von Laserschüssen (130),
d) wenn sich die Speicherzelle in einem geformten Zustand befindet, Ausführen eines Nachformungszyklus (140), um die Zelle in einen betriebsbereiten Zustand zu versetzen.

3. Formgebungsverfahren nach Anspruch 2, **dadurch gekennzeichnet, dass** die Schritte a)-c) wiederholt werden, solange sich die Speicherzelle (10) in einem nicht-geformten Zustand befindet, wobei die, Flächenleistung des Laserschusses bei jeder Wiederholung des Schritts c) erhöht wird.

4. Formgebungsverfahren nach einem der Ansprüche 2 bis 3, **dadurch gekennzeichnet, dass** der Nachformungszyklus (140) in Schritt d) mehrere aufeinanderfolgende und umkehrbare Zyklen des Umschaltens zwischen dem HRS-Zustand und dem LRS-Zustand umfasst.

5. Formgebungsverfahren nach einem der Ansprüche 1 bis 4, **dadurch gekennzeichnet, dass** der Durchschlagvorgang mit einem Laser mit einer Flächenleistung zwischen 0,06 und 0,12W/µm² durchgeführt wird.

6. Formgebungsverfahren nach einem der Ansprüche 1 bis 5, **dadurch gekennzeichnet, dass** der Durchschlagvorgang mit einem Laserstrahl mit einem Durchmesser von mehr als dem Dreifachen der Breite und/oder Länge der Speicherzelle durchgeführt wird.

7. Formgebungsverfahren nach einem der Ansprüche 1 bis 6, **dadurch gekennzeichnet, dass** der Durchschlagvorgang mit einem Laser durchgeführt wird, dessen Impulse eine Dauer von 1 µs oder weniger haben.

8. Formgebungsverfahren nach einem der Ansprüche 1 bis 7, **dadurch gekennzeichnet, dass** der Durchschlagvorgang mit einem Laserstrahl durchgeführt wird, der in einer Wellenlänge im infraroten oder ultravioletten Bereich abgegeben wird.

9. Nichtflüchtige Speicherzelle (10), die eine geordnete Schichtung aus einer unteren Elektrode (12), einer Schicht aus Isoliermaterial (13) und einer oberen Elektrode (11) umfasst,
**dadurch gekennzeichnet, dass** die Schicht aus Isoliermaterial (13) durch ein Formgebungsverfahren nach einem der Ansprüche 2 bis 4 aktiviert wird, sodass die Schicht aus Isoliermaterial nach dem Formen in der Lage ist, reversibel zwischen einem hochfesten Zustand (HRS-Zustand) und einem niedrigfesten Zustand (LRS-Zustand) umzuschalten.

10. Speicherzelle nach Anspruch 9, **dadurch gekennzeichnet, dass** die obere Elektrode aus Titan (Ti) besteht, die untere Elektrode aus Titannitrid (TiN) besteht und die Schicht aus Isoliermaterial aus Hafniumoxid (HfO₂) besteht.

11. Speicherzelle nach Anspruch 9 oder 10, **dadurch gekennzeichnet, dass** sie eine Auswahlvorrichtung enthält, die mit der Schichtung aus der unteren Elektrode, der Schicht aus Isoliermaterial und der oberen Elektrode verbunden ist, um den durch die Schichtung fließenden Strom zu kontrollieren.

12. Mikroelektronische Vorrichtung (20) mit einer Vielzahl von Speicherzellen (10) nach einem der Ansprüche 9 bis 11, die nebeneinander angeordnet sind.

13. Mikroelektronische Vorrichtung nach Anspruch 12, **dadurch gekennzeichnet, dass** die Speicherzellen (10) in einer kreuzförmigen Architektur angeordnet sind.

## Claims

1. Method for forming (100) a non-volatile memory cell intended to switch said memory cell (10) from an unformed state to a formed state, said memory cell including an ordered stack of a lower electrode (12), a layer of insulating material (13) and an upper electrode (11),
**characterised in that** it comprises a breakdown operation (110-130) in which at least one laser shot is emitted towards the layer of insulating material (13) to make said layer of insulating material active by making it pass from a high resistance state (HRS state) to a low resistance state (LRS state), the memory cell being formed when the layer of insulating material is active, several laser shots being able to be emitted successively towards the layer of insulating material (13) with, each, a laser shot power flux density greater than the laser shot power flux density of the preceding laser shot, a first laser shot being applied with a predetermined base power flux density, the following laser shots being applied with a power flux density increased step by step until one of the laser shots causes the breakdown of the layer of insulating material (13).

2. Method for forming according to claim 1, **characterised in that** it comprises the following steps:
a) reading (110) the memory cell,
b) detecting (120) the formed or unformed state of said memory cell,
c) when the memory cell is in an unformed state, implementing laser shots (130),
d) when the memory cell is in a formed state, carrying out a post-forming cycle (140) to place said cell in an operating state.

3. Method for forming according to claim 2, **characterised in that** steps a) - c) are repeated as long as the memory cell (10) is in an unformed state, the power flux density of the laser shot being increased at each repetition of step c).

4. Method for forming according to any of claims 2 to 3, **characterised in that** the post-forming cycle (140) of step d) comprises several cycles, successive and reversible, of switching between the HRS state and the LRS state.

5. Method for forming according to any of claims 1 to 4, **characterised in that** the breakdown operation is carried out with a laser of a power flux density comprised between 0.06 and 0.12 W/µm².

6. Method for forming according to any of claims 1 to 5, **characterised in that** the breakdown operation is carried out with a laser beam of a diameter greater than three times the width and/or the length of the memory cell.

7. Method for forming according to any of claims 1 to 6, **characterised in that** the breakdown operation is carried out with a laser in which the pulses have a duration less than or equal to 1µs.

8. Method for forming according to any of claims 1 to 7, **characterised in that** the breakdown operation is carried out with a laser beam emitted in a wavelength of the infrared or the ultraviolet.

9. Non-volatile memory cell (10) including an ordered stack of a lower electrode (12), a layer of insulating material (13) and an upper electrode (11), **characterised in that** the layer of insulating material (13) is made active by a forming method according to any of claims 2 à 4 such that said layer of insulating material is capable, after forming, to switch in a reversible manner between a high resistance state (HRS state) and a low resistance state (LRS state).

10. Memory cell according to claim 9, **characterised in that** the upper electrode is made of titanium (Ti), the lower electrode is made of titanium nitride (TiN) and the layer of insulating material is made of hafnium oxide (HfO₂).

11. Memory cell according to claim 9 or 10, **characterised in that** it comprises a selection device, connected to the stack of the lower electrode, the layer of insulating material and the upper electrode, to control the current flowing in said stack.

12. Microelectronic device (20) comprising a plurality of memory cells (10) according to any of claims 9 to 11, laid out beside each other.

13. Microelectronic device according to claim 12, **characterised in that** the memory cells (10) are laid out in a crossbar type architecture.
